# EUROPÄISCHE PATENTANMELDUNG

(11) **EP 2 919 268 A1**
(43) Veröffentlichungstag der Anmeldung: **16.09.2015**
(21) Anmeldenummer: 15155680.0
(22) Anmeldetag: 19.02.2015
(51) Int. Cl.: H01L 27/146

(54) **OPTISCHE ERFASSUNGSVORRICHTUNG UND VERFAHREN ZUM HERSTELLEN EINER OPTISCHEN ERFASSUNGSVORRICHTUNG**

(30) Priorität: 13.03.2014 DE 102014204647
(71) Anmelder: ROBERT BOSCH GMBH, 70442 Stuttgart (DE)
(72) Erfinder: Kronmueller, Silvia, 71409 Schwaikheim (DE); Schelling, Christoph, 70597 Stuttgart (DE)

(57) **Zusammenfassung**

Die Erfindung betrifft eine optische Erfassungsvorrichtung (100), die ein optisches Detektorelement (122) und eine Auswerteeinrichtung (130) aufweist. Die optische Erfassungsvorrichtung (100) weist ein Detektorsubstrat (124) zum Tragen des optischen Detektorelements (122) auf. Dabei sind das Detektorsubstrat (124) und die Auswerteeinrichtung (130) aufeinander gestapelt angeordnet.

## Beschreibung

### Stand der Technik

Die vorliegende Erfindung bezieht sich auf eine optische Erfassungsvorrichtung und auf ein Verfahren zum Herstellen einer optischen Erfassungsvorrichtung.

Auf dem Gebiet der Sensorik beispielsweise werden häufig optische Sensorcluster eingesetzt. In der US 2013/0012276 A1 ist ein Gehäuse für einen optischen Sensor beschrieben, das sowohl eine Lichtquelle als auch einen Lichtempfänger umfasst.

### Offenbarung der Erfindung

Vor diesem Hintergrund werden mit dem hier vorgestellten Ansatz eine optische Erfassungsvorrichtung und ein Verfahren zum Herstellen einer optischen Erfassungsvorrichtung gemäß den Hauptansprüchen vorgestellt. Vorteilhafte Ausgestaltungen ergeben sich aus den jeweiligen Unteransprüchen und der nachfolgenden Beschreibung.

Gemäß Ausführungsformen der Erfindung können bei einer optischen Erfassungsvorrichtung insbesondere eine Auswerteschaltung und ein Detektorelement auf getrennten Halbleitersubstraten realisiert sein bzw. werden. So kann ein Stapel aus den die Auswerteschaltung und das Detektorelement tragenden Halbleitersubstraten gebildet sein bzw. werden. Eine solche optische Erfassungsvorrichtung kann beispielsweise in der Sensorik vorteilhaft für optische Sensoren bzw. Sensorcluster, z. B. für eine UV- und RGB- (Rot-Grün-Blau) Intensitätsmessung, eingesetzt werden.

Vorteilhafterweise können gemäß Ausführungsformen der Erfindung die Auswerteschaltung und das Detektorelement beispielsweise unabhängig voneinander optimiert werden, da die Auswerteschaltung und das Detektorelement auf getrennten Halbleitersubstraten realisiert sind. Ausführungsformen der Erfindung ermöglichen insbesondere eine Realisierung eines kostengünstigen optischen Sensors bzw. Sensorgehäuses mit kleinem Formfaktor für optische Sensoren. Das Gehäuse bzw. die optische Erfassungsvorrichtung kann klein ausgeführt sein und lediglich wenig Montagefläche benötigen. Es kann durch einen solchen modularen Aufbau ferner eine hohe Flexibilität bei minimaler Baugröße erreicht werden.

Es wird eine optische Erfassungsvorrichtung vorgestellt, die ein optisches Detektorelement und eine Auswerteeinrichtung aufweist, dadurch gekennzeichnet, dass die optische Erfassungsvorrichtung ein Detektorsubstrat zum Tragen des optischen Detektorelements aufweist, wobei das Detektorsubstrat und die Auswerteeinrichtung aufeinander gestapelt angeordnet sind.

Das Detektorsubstrat kann als eine Leiterplatte, ein Halbleitersubstrat oder dergleichen ausgeformt sein. Bei der Auswerteeinrichtung kann es sich um eine Auswerteschaltung handeln. Unter einer Vorrichtung bzw. Erfassungsvorrichtung kann vorliegend ein elektrisches Gerät verstanden werden, das Sensorsignale verarbeitet und in Abhängigkeit davon Steuer- und/oder Datensignale ausgibt. Die Vorrichtung bzw. Erfassungsvorrichtung kann zumindest eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung bzw. Erfassungsvorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Auch kann die optische Erfassungsvorrichtung ein Auswertesubstrat zum Tragen der Auswerteeinrichtung aufweisen. Dabei kann das Auswertesubstrat als eine Leiterplatte, ein Halbleitersubstrat oder dergleichen ausgeformt sein.

Gemäß einer Ausführungsform kann die Auswerteeinrichtung in das Auswertesubstrat eingebettet sein. Dabei kann die Auswerteeinrichtung als eine Auswerteschaltung in dem Auswertesubstrat angeordnet sein. Durch eine solche Einbettung der Auswerteeinrichtung bzw. Auswerteschaltung in ein Trägersubstrat, z. B. eine Leiterplatte, kann die Auswerteeinrichtung vorteilhaft vor äußeren Einflüssen geschützt werden. Ferner kann einfach und kostengünstig eine Umverdrahtung von einer Schaltungsseite auf eine gegenüberliegende Seite des Auswertesubstrats erfolgen, ohne einen teuren TSV-Prozess (TSV = Through Silicon Via; Silizium-Durchkontaktierung) zu benötigen.

Insbesondere können eine Grundfläche des Detektorelements und eine Grundfläche der Auswerteeinrichtung innerhalb eines Toleranzbereichs gleich groß sein. Auch können eine Grundfläche des Detektorsubstrats und eine Grundfläche des Auswertesubstrats innerhalb eines Toleranzbereichs gleich groß sein. Dabei können das optische Detektorelement bzw. das Detektorsubstrat und die Auswerteeinrichtung bzw. das Auswertesubstrat mit eingebetteter Auswerteeinrichtung innerhalb eines Toleranzbereichs dieselben Lateralabmessungen aufweisen und aufeinander gestapelt sein. Auch ein optisches Element der optischen Erfassungsvorrichtung kann eine Grundfläche aufweisen, die kleiner oder gleich der Grundfläche des Detektorsubstrats und der Grundfläche des Auswertesubstrats ist. Eine solche Ausführungsform bietet den Vorteil, dass sich eine minimale Bauelementegröße bzw. Größe der optischen Erfassungsvorrichtung ergibt. Somit kann eine solche optische Erfassungsvorrichtung besonders platzsparend bzw. mit besonders günstigem Formfaktor ausgeführt sein.

Auch können Anschlusskontakte zum externen elektrischen Kontaktieren der optischen Erfassungsvorrichtung an einer detektorseitigen oder einer auswerteseitigen Außenfläche der optischen Erfassungsvorrichtung angeordnet sein. Die Anschlusskontakte bzw. Kontaktpads können mittels Durchkontakten bzw. Silizium-Durchkontakten (TSVs = Through Silicon Vias) durch das Auswertesubstrat bzw. die Auswerteeinrichtung oder das Detektorsubstrat nach außen geführt sein. Eine solche Ausführungsform bietet den Vorteil, dass eine einfache und flexible Integration der optischen Erfassungsvorrichtung beispielsweise in ein Gerätegehäuse ermöglicht ist, da die optische Erfassungsvorrichtung bzw. ein Gehäuse der optischen Erfassungsvorrichtung vorteilhaft entweder auf Seite des Detektorsubstrats oder des Auswertesubstrats bzw. der Auswerteeinrichtung Kontaktpads aufweisen kann, also die Kontaktpads nicht zwangsweise auf der Seite des Trägersubstrates liegen.

Ferner kann ein optisches Element vorgesehen sein, das direkt, spaltfrei und zusätzlich oder alternativ ohne Klebeschicht an das optische Detektorelement angrenzend angeordnet sein kann. Das optische Element kann je nach Anwendung als Linse oder als komplanares Fenster ausgeführt sein. Eine Verbindung zwischen optischem Element und optischem Detektorelement kann beispielsweise entweder durch direktes Bonden oder mittels einer Klebezwischenschicht erfolgen. Eine solche Ausführungsform bietet den Vorteil, dass durch eine Vermeidung eines Spaltes zwischen dem optischen Element und dem optischen Detektorelement Lichtverluste durch Reflexionen an zusätzlichen zwei Grenzflächen optisches Element-Luft und Luft-Detektorelement vermieden werden können. Durch den fehlenden Spalt zwischen optischem Element und optischem Detektorelement ergibt sich eine höhere Quanteneffizienz bzw. eine größere Empfindlichkeit. Das optische Element kann ferner eine direkte Verschmutzung des optischen Detektorelements verhindern.

Zumindest eine Außenoberfläche des optischen Elements kann von einer Gehäuseaußenseite der optischen Erfassungsvorrichtung her optisch zugänglich angeordnet sein. Hierbei kann zumindest eine von dem optischen Detektorelement abgewandte Oberfläche des optischen Elements frei von einem Gehäusematerial der optischen Erfassungsvorrichtung sein. Eine solche Ausführungsform bietet den Vorteil, dass ein Gehäuse der optischen Erfassungseinrichtung auf einfache Weise ausgeformt oder angeordnet werden kann, ohne eine Erfassungsqualität der Vorrichtung zu beeinträchtigen.

Gemäß einer Ausführungsform kann zumindest das optische Detektorelement in einer Vergussmasse eingebettet sein. Auch kann zusätzlich das optische Element in der Vergussmasse eingebettet sein. Optional können auch das Detektorsubstrat und gegebenenfalls das Auswertesubstrat in der Vergussmasse eingebettet sein. Die Vergussmasse kann ein Kunststoffmaterial aufweisen. Eine solche Ausführungsform bietet den Vorteil, dass eine solche Art der Verpackung eine kostengünstige Verpackungsform für optische Sensoren darstellt. Überragt das optische Element eine Oberfläche der Vergussmasse, so kann beim Verpacken eine Gefahr verringert oder beseitigt werden, dass das optische Element beim Verpacken verschmutzt würde. Ferner besteht eine verbesserte Integrationsmöglichkeit der verpackten optischen Erfassungsvorrichtung in ein Gerätegehäuse, z. B. ein Mobiltelefon-Gehäuse.

Auch können das optische Detektorelement und die Auswerteeinrichtung mittels durch das Detektorsubstrat hindurch gebildeter Durchkontakte sowie eines zwischen dem Detektorsubstrat und der Auswerteeinrichtung angeordneten, umlaufenden Dichtrings miteinander verbunden sein. Bei den Durchkontakten kann es sich um Silizium-Durchkontaktierungen oder dergleichen handeln. Eine solche Ausführungsform bietet den Vorteil, dass das optische Detektorelement und die Auswerteeinrichtung über die Durchkontakte durch das Detektorsubstrat und den umlaufenden Dichtring auf einfache und platzsparende Weise miteinander verbindbar sind. Der umlaufende Dichtring hat zudem den Vorteil, Signalleitungen vor äußeren Einflüssen, wie beispielsweise verunreinigenden Medien, elektromagnetische Interferenz oder dergleichen zu schützen.

Dabei können die Durchkontakte und der Dichtring aus demselben Material ausgeformt sein. Insbesondere können hierbei die Durchkontakte und der Dichtring aus einem metallischen Material ausgeformt sein. Eine solche Ausführungsform bietet den Vorteil, dass es besonders kostengünstig ist, wenn Dichtring und Durchkontakte aus demselben Material hergestellt sind.

Es wird ein Verfahren zum Herstellen einer optischen Erfassungsvorrichtung vorgestellt, wobei das Verfahren folgende Schritte aufweist:
Stapeln eines Detektorsubstrats, an dem ein optisches Detektorelement angeordnet ist, und einer Auswerteeinrichtung aufeinander;
Herstellen einer elektrisch leitfähigen Verbindung zwischen dem optischen Detektorelement und der Auswerteeinrichtung;
Anordnen eines optischen Elements angrenzend an das optische Detektorelement; und
Verpacken zumindest des optischen Detektorelements und eines Teilabschnitts des optischen Elements mit einem Gehäusematerial.

Durch Ausführen des Verfahrens kann eine Ausführungsform der vorstehend genannten optischen Erfassungsvorrichtung vorteilhaft hergestellt werden. Das Verfahren kann ferner einen Schritt des Erzeugens von Anschlusskontakten zum externen elektrischen Kontaktieren der optischen Erfassungsvorrichtung an einer detektorseitigen oder einer auswerteseitigen Außenfläche der optischen Erfassungsvorrichtung aufweisen.

Der hier vorgestellte Ansatz wird nachstehend anhand der beigefügten Zeichnungen beispielhaft näher erläutert. Es zeigen:
Figuren 1 bis 6 schematische Schnittdarstellungen von optischen Erfassungsvorrichtungen gemäß Ausführungsbeispielen der vorliegenden Erfindung; und
Fig. 7 ein Ablaufdiagramm eines Verfahrens zum Herstellen einer optischen Erfassungsvorrichtung gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

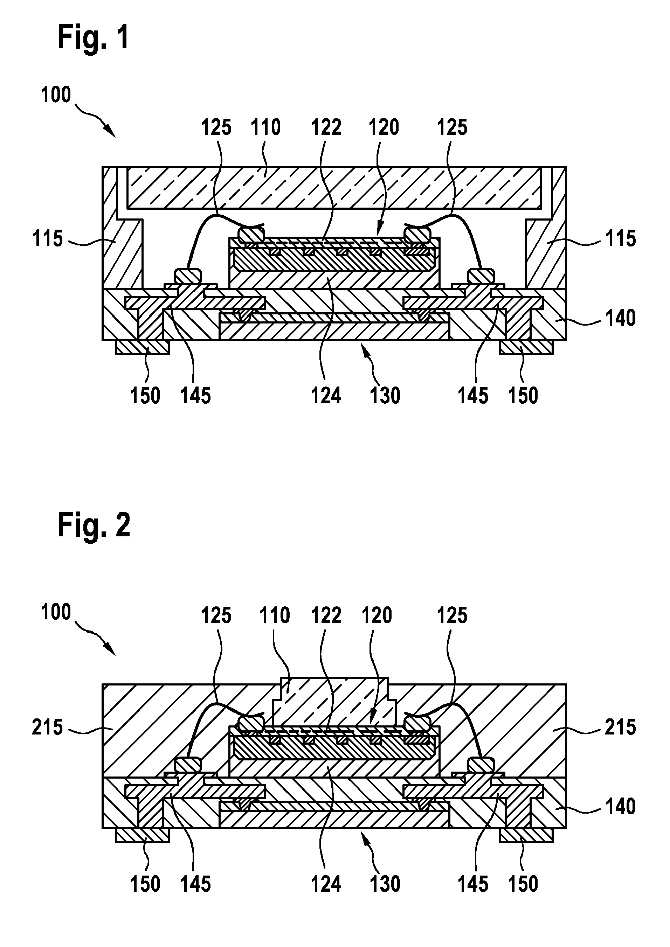

Fig. 1 zeigt eine schematische Schnittdarstellung einer optischen Erfassungsvorrichtung 100 gemäß einem Ausführungsbeispiel der vorliegenden Erfindung. Gezeigt sind von der optischen Erfassungsvorrichtung 100 hierbei ein optisches Element 110, ein Deckel 115, ein Sensorchip 120, ein optisches Detektorelement 122, ein Detektorsubstrat 124, Drahtbonds 125, eine Auswerteeinrichtung 130, ein Auswertesubstrat 140, elektrische Leiter 145 und Anschlusskontakte 150. Die optische Erfassungsvorrichtung 100 ist beispielsweise für optische Sensoren beispielsweise zur UV- und RGB-Intensitätsmessung einsetzbar.

Das optische Element 110 ist gemäß dem in Fig. 1 dargestellten Ausführungsbeispiel der vorliegenden Erfindung als ein Fenster, beispielsweise ein Deckglas aus Quarz, Magnesiumoxid, Aluminiumoxid oder dergleichen ausgeformt. Das optische Element 110 weist hierbei zwei komplanare Hauptoberflächen auf. Mittels des Deckels 115 ist das optische Element 110 an dem Auswertesubstrat 140 fixiert. Bei dem Deckel 115 handelt es sich beispielsweise um einen Metalldeckel. Eine von dem Auswertesubstrat 140 abgewandte Hauptoberfläche des optischen Elements 110 ist von einer Außenseite der optischen Erfassungsvorrichtung 100 her optisch zugänglich bzw. repräsentiert einen Teilabschnitt einer Außenoberfläche der optischen Erfassungsvorrichtung 100.

Der Sensorchip 120 ist an dem Auswertesubstrat 140 angebracht. Dabei ist der Sensorchip 120 zwischen dem optischen Element 110 und dem Auswertesubstrat 140 angeordnet. Der Sensorchip 120 weist das optische Detektorelement 122 und das Detektorsubstrat 124 auf. Dabei ist das optische Detektorelement 122 dem optischen Element 110 zugewandt angeordnet. Das Detektorsubstrat 124 ist dem Auswertesubstrat 140 zugewandt angeordnet. Mittels der Drahtbonds 125 ist der Sensorchip 120 elektrisch leitfähig mit dem Auswertesubstrat 140 verbunden. Genau gesagt ist das optische Detektorelement 122 mittels der Drahtbonds 125 elektrisch leitfähig mit dem Auswertesubstrat 140 verbunden.

Die Auswerteeinrichtung 130 ist in dem Auswertesubstrat 140 eingebettet angeordnet. Bei der Auswerteeinrichtung 130 bzw. Auswerteschaltung handelt es sich beispielsweise um eine anwendungsspezifische integrierte Schaltung (ASIC = Application-Specific Integrated Circuit). Das Auswertesubstrat 140 ist hierbei als eine Leiterplatte ausgeführt. Der Deckel 115 ist an einer dem optischen Element 110 zugewandten Hauptoberfläche des Auswertesubstrats 140 angebracht. In dem Auswertesubstrat 140 sind die elektrischen Leiter 145 ausgeformt. Die elektrischen Leiter 145 erstrecken sich von Kontaktstellen mit den Drahtbonds 125 an der dem optischen Element 110 zugewandten Hauptoberfläche des Auswertesubstrats 140 sowohl zu der Auswerteeinrichtung 130 als auch zu den Anschlusskontakten 150 bzw. Kontaktpads, die an einer von dem optischen Element 110 abgewandten Hauptoberfläche des Auswertesubstrats 140 angeordnet sind. Die Anschlusskontakte 150 sind ausgebildet, um ein elektrisches Kontaktieren der optischen Erfassungsvorrichtung 100 von außen zu ermöglichen. Die von dem optischen Element 110 abgewandte Hauptoberfläche des Auswertesubstrats 140 repräsentiert einen weiteren Teilabschnitt der Außenoberfläche der optischen Erfassungsvorrichtung 100.

Somit weist die optische Erfassungsvorrichtung 100 einen Stapel auf, in dem das Auswertesubstrat 140 und das Detektorsubstrat 124 sowie das optische Element 110 gestapelt sind. Anders ausgedrückt weist die optische Erfassungsvorrichtung 100 einen Stapel auf, in dem die Auswerteeinrichtung 130, der Sensorchip 120 bzw. das optische Detektorelement 122 sowie das optische Element 110 gestapelt sind. Hierbei sind eine Grundfläche des Sensorchips 120 und eine Grundfläche der Auswerteeinrichtung 130 innerhalb eines Toleranzbereichs gleich groß.

Mit anderen Worten ist in Fig. 1 ein Querschnitt durch die optische Erfassungsvorrichtung 100 bzw. ein Gehäuse der optischen Erfassungsvorrichtung 100 dargestellt. Das Auswertesubstrat 140 bzw. die Leiterplatte ist als ein Trägersubstrat der optischen Erfassungsvorrichtung 100 ausgeformt. Die Anschlusskontakte 150 bzw. Kontaktpads sind auf der Seite des Auswertesubstrats 140 bzw. auf der Trägersubstratseite der optischen Erfassungsvorrichtung 100 angeordnet. Die Auswerteeinrichtung bzw. der ASIC 130 ist in dem Auswertesubstrat 140 bzw. der Leiterplatte eingebettet. Das optische Element 110 ist hierbei als ein Fenster für Lichteinfall vorgesehen und mittels des Deckels 115, z. B. einem Metalldeckel, fixiert. Gemäß einem Ausführungsbeispiel kann das optische Element 110 als eine Mikrolinse ausgeformt sein.

Fig. 2 zeigt eine schematische Schnittdarstellung einer optischen Erfassungsvorrichtung 100 gemäß einem Ausführungsbeispiel der vorliegenden Erfindung. Gezeigt sind von der optischen Erfassungsvorrichtung 100 hierbei ein optisches Element 110, ein Sensorchip 120, ein optisches Detektorelement 122, ein Detektorsubstrat 124, Drahtbonds 125, eine Auswerteeinrichtung 130, ein Auswertesubstrat 140, elektrische Leiter 145, Anschlusskontakte 150 und eine Vergussmasse 215 bzw. Moldverpackung.

Dabei entspricht die in Fig. 2 gezeigte optische Erfassungsvorrichtung 100 der optischen Erfassungsvorrichtung aus Fig. 1 mit der Ausnahme, dass das optische Element 110 direkt an dem Sensorchip 120 bzw. dem optischen Detektorelement 122 angeordnet ist und dass anstelle des Deckels die Vergussmasse 215 angeordnet ist. Das optische Element 110 ist direkt, spaltfrei bzw. ohne Klebeschicht an dem Sensorchip 120 angeordnet. Mittels der Vergussmasse 215 sind der Sensorchip 120, die Drahtbonds 125 und ein Teilabschnitt des optischen Elements 110 eingegossen. Die von dem Sensorchip 120 abgewandte Hauptoberfläche des optischen Elements 110 überragt die Vergussmasse 215. Somit ist die von dem Sensorchip 120 abgewandte Hauptoberfläche des optischen Elements 110 freiliegend.

Mit anderen Worten ist in Fig. 2 ein Querschnitt durch die optische Erfassungsvorrichtung 100 bzw. ein Gehäuse der optischen Erfassungsvorrichtung 100 dargestellt. Das optische Element 110 ist hierbei als ein Fenster für Lichteinfall vorgesehen. Es ergibt sich eine verbesserte Lichteinkopplung durch die spaltfreie Montage des optischen Elements 110 auf dem Sensorchip 120. Dazu kann ein angesägten Glaswafer auf den Sensorchip 120 aufgebondet werden. Gemäß einem Ausführungsbeispiel kann das optische Element 110 als eine Mikrolinse ausgeformt sein.

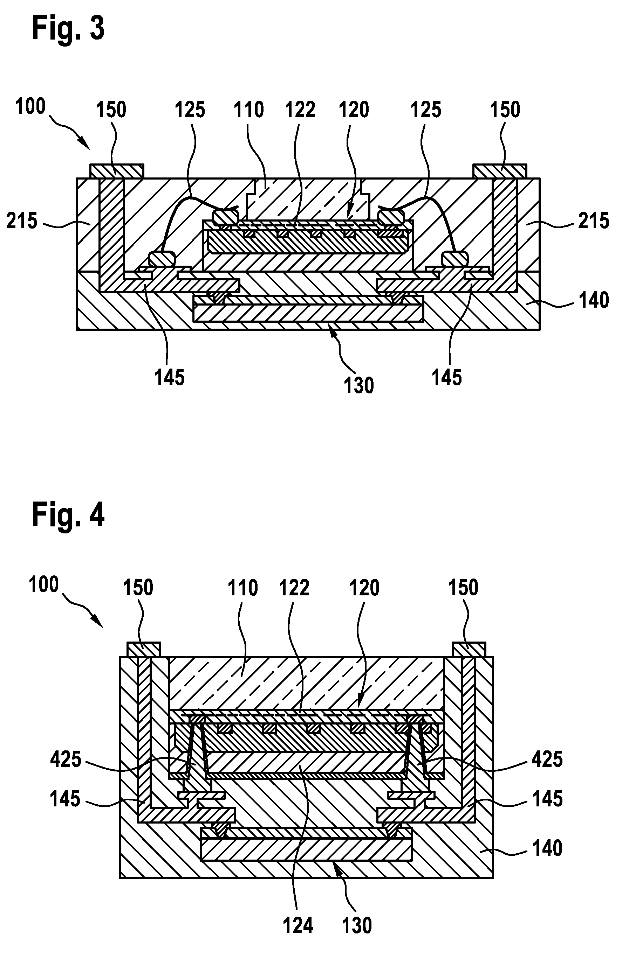

Fig. 3 zeigt eine schematische Schnittdarstellung einer optischen Erfassungsvorrichtung 100 gemäß einem Ausführungsbeispiel der vorliegenden Erfindung. Gezeigt sind von der optischen Erfassungsvorrichtung 100 hierbei ein optisches Element 110, ein Sensorchip 120, ein optisches Detektorelement 122, ein Detektorsubstrat 124, Drahtbonds 125, eine Auswerteeinrichtung 130, ein Auswertesubstrat 140, elektrische Leiter 145, Anschlusskontakte 150 und eine Vergussmasse 215 bzw. Moldverpackung.

Die in Fig. 3 gezeigte optische Erfassungsvorrichtung 100 entspricht dabei der optischen Erfassungsvorrichtung aus Fig. 2 mit der Ausnahme, dass die Anschlusskontakte 150 bzw. Kontaktpads auf der Seite des optischen Elements 110 der optischen Erfassungsvorrichtung 100 angeordnet sind. Hierbei sind die Anschlusskontakte 150 an einer Außenoberfläche der Vergussmasse 215 auf der Seite des optischen Elements 110 angeordnet. Die elektrischen Leiter 145 erstrecken sich von Kontaktstellen mit den Drahtbonds 125 an der dem optischen Element 110 zugewandten Hauptoberfläche des Auswertesubstrats 140 sowohl durch das Auswertesubstrat 140 hindurch zu der Auswerteeinrichtung 130 als auch durch die Vergussmasse 215 hindurch zu den Anschlusskontakten 150.

Fig. 4 zeigt eine schematische Schnittdarstellung einer optischen Erfassungsvorrichtung 100 gemäß einem Ausführungsbeispiel der vorliegenden Erfindung. Gezeigt sind von der optischen Erfassungsvorrichtung 100 hierbei ein optisches Element 110, ein Sensorchip 120, ein optisches Detektorelement 122, ein Detektorsubstrat 124, eine Auswerteeinrichtung 130, ein Auswertesubstrat 140, elektrische Leiter 145, Anschlusskontakte 150 und Durchkontakte 425.

Dabei entspricht die in Fig. 4 gezeigte optische Erfassungsvorrichtung 100 der optischen Erfassungsvorrichtung aus Fig. 3 mit der Ausnahme, dass das Auswertesubstrat 140 einen vertieften Abschnitt aufweist, in dem der Sensorchip 120 und das optische Element 110 gestapelt aufgenommen angeordnet sind, dass keine Vergussmasse vorgesehen ist und dass anstelle der Drahtbonds die Durchkontakte 425 angeordnet sind, mittels derer der Sensorchip 120 mit den elektrischen Leitern 145 elektrisch leitfähig verbunden ist.

Das Auswertesubstrat 140 weist gemäß dem in Fig. 4 dargestellten Ausführungsbeispiel der vorliegenden Erfindung in der Schnittdarstellung ein U-förmiges, schüsselförmiges bzw. trogförmiges Querschnittsprofil auf. Durch das Querschnittsprofil ist der vertiefte Abschnitt des Auswertesubstrats 140 bedingt. In dem vertieften Abschnitt des Auswertesubstrats 140 ist der Sensorchip 120 angeordnet und mit dem optischen Element 110 abgedeckt. Dabei sind der Sensorchip 120 und das optische Element 110 passend in dem vertieften Abschnitt des Auswertesubstrats 140 aufgenommen. Der Sensorchip 120 ist zwischen der Auswerteschaltung 130 und dem optischen Element 110 angeordnet. Das optische Element 110 ist direkt bzw. spaltfrei an das optische Detektorelement 122 des Sensorchips 120 angrenzend angeordnet. Das optische Element 110 fungiert auch als ein Deckel oder Abschlusselement des vertieften Abschnitts des Auswertesubstrats 140. Das optische Element 110 ist hierbei zwischen den Anschlusskontakten 150 angeordnet. Die von dem Sensorchip 120 abgewandte Hauptoberfläche des optischen Elements 110 ist hierbei von außen freiliegend und optisch zugänglich.

Der Sensorchip 120 bzw. das optische Detektorelement 122 ist mittels der Durchkontakte 425 mit den elektrischen Leitern 145 in dem Auswertesubstrat 140 elektrisch leitfähig verbunden. Die Durchkontakte 425 sind beispielsweise als Silizium-Durchkontaktierungen (TSVs = Through-Silicon Vias) ausgeführt. Dabei erstrecken sich die Durchkontakte 425 durch das Detektorsubstrat 124 hindurch und in das Auswertesubstrat 140 hinein. Die elektrischen Leiter 145 erstrecken sich von Kontaktstellen mit den Durchkontakten 425 durch das Auswertesubstrat 140 hindurch sowohl zu der Auswerteeinrichtung 130 als auch zu den Anschlusskontakten 150.

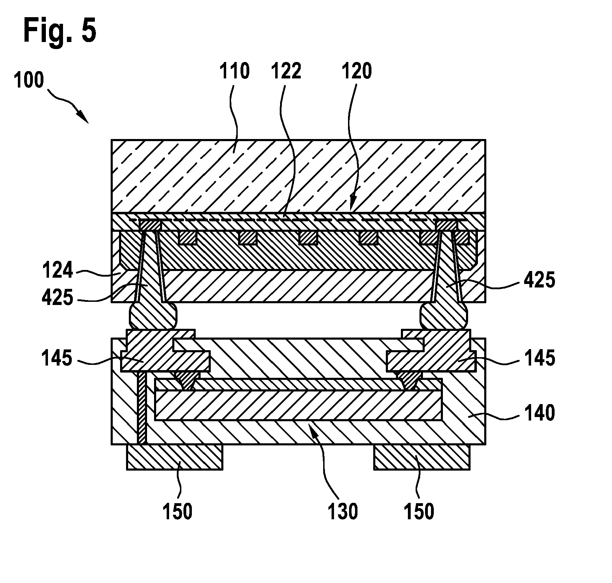

Fig. 5 zeigt eine schematische Schnittdarstellung einer optischen Erfassungsvorrichtung 100 gemäß einem Ausführungsbeispiel der vorliegenden Erfindung. Gezeigt sind von der optischen Erfassungsvorrichtung 100 hierbei ein optisches Element 110, ein Sensorchip 120, ein optisches Detektorelement 122, ein Detektorsubstrat 124, eine Auswerteeinrichtung 130, ein Auswertesubstrat 140, elektrische Leiter 145, Anschlusskontakte 150 und Durchkontakte 425.

Dabei entspricht die in Fig. 5 gezeigte optische Erfassungsvorrichtung 100 der optischen Erfassungsvorrichtung aus Fig. 4 mit der Ausnahme, dass die Anschlusskontakte 150 auf der von dem optischen Element 110 abgewandten Hauptoberfläche des Auswertesubstrats 140 angeordnet sind und das Auswertesubstrat 140 plattenförmig ausgeformt ist.

Gemäß dem in Fig. 5 dargestellten Ausführungsbeispiel der vorliegenden Erfindung weisen das optische Element 110, der Sensorchip 120 und das Auswertesubstrat 140 im Wesentlichen eine gleichgroße Grundfläche auf. Das optische Element 110, der Sensorchip 120 und das Auswertesubstrat 140 mit der in demselben eingebetteten Auswerteeinrichtung 130 sind hierbei übereinander gestapelt angeordnet.

Das optische Element 110 ist mit dem optischen Erfassungselement 122 des Sensorchips 120 direkt bzw. spaltfrei verbunden. Der Sensorchip 120 bzw. das optische Detektorelement 122 ist mittels der Durchkontakte 425 mit den elektrischen Leitern 145 in dem Auswertesubstrat 140 elektrisch leitfähig verbunden. Die Durchkontakte 425 sind beispielsweise als Silizium-Durchkontaktierungen (TSVs = Through-Silicon Vias) ausgeführt. Dabei erstrecken sich die Durchkontakte 425 durch das Detektorsubstrat 124 hindurch. Die elektrischen Leiter 145 erstrecken sich von Kontaktstellen mit den Durchkontakten 425 auf der dem Sensorchip 120 zugewandten Hauptoberfläche des Auswertesubstrats 140 durch das Auswertesubstrat 140 hindurch sowohl zu der Auswerteeinrichtung 130 als auch zu den Anschlusskontakten 150 auf der von dem Sensorchip 120 abgewandten Hauptoberfläche des Auswertesubstrats 140.

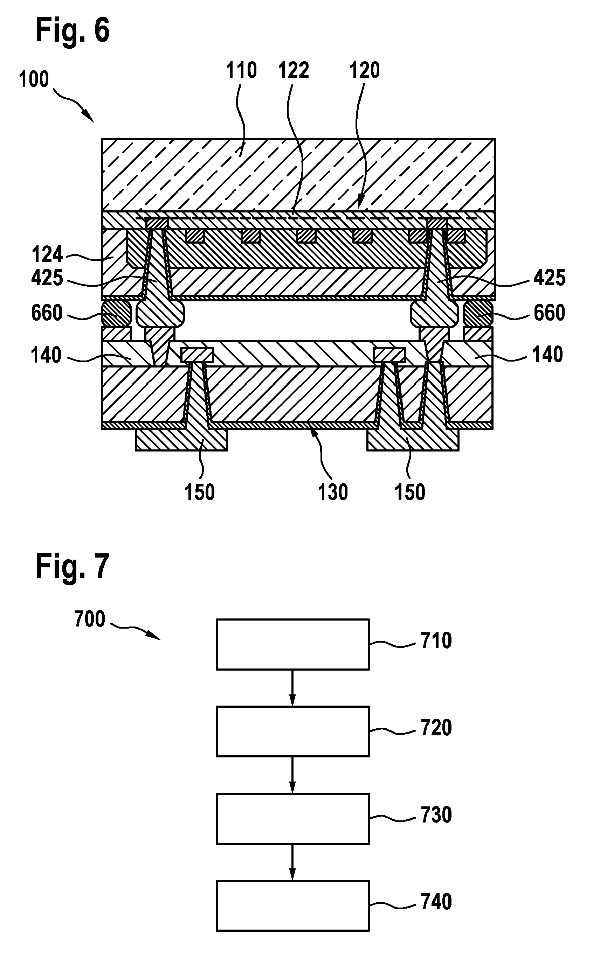

Fig. 6 zeigt eine schematische Schnittdarstellung einer optischen Erfassungsvorrichtung 100 gemäß einem Ausführungsbeispiel der vorliegenden Erfindung. Gezeigt sind von der optischen Erfassungsvorrichtung 100 hierbei ein optisches Element 110, ein Sensorchip 120, ein optisches Detektorelement 122, ein Detektorsubstrat 124, eine Auswerteeinrichtung 130, Anschlusskontakte 150, Durchkontakte 425 und ein Dichtring 660.

Dabei entspricht die in Fig. 6 gezeigte optische Erfassungsvorrichtung 100 der optischen Erfassungsvorrichtung aus Fig. 5 mit der Ausnahme, dass der Dichtring 660 zwischen dem Sensorchip 120 und der Auswerteeinrichtung 130 angeordnet ist und die Auswerteeinrichtung 130 uneingebettet dargestellt ist.

Gemäß dem in Fig. 6 dargestellten Ausführungsbeispiel der vorliegenden Erfindung weisen das optische Element 110, der Sensorchip 120 und die Auswerteeinrichtung 130 im Wesentlichen eine gleichgroße Grundfläche auf. Das optische Element 110, der Sensorchip 120 und die Auswerteeinrichtung 130 sind hierbei übereinander gestapelt angeordnet. Das optische Element 110 ist mit dem optischen Erfassungselement 122 des Sensorchips 120 direkt bzw. spaltfrei verbunden.

Der Sensorchip 120 bzw. das optische Detektorelement 122 ist mittels der Durchkontakte 425 mit der Auswerteeinrichtung 130 elektrisch leitfähig verbunden. Die Durchkontakte 425 sind beispielsweise als Silizium-Durchkontaktierungen (TSVs = Through-Silicon Vias) ausgeführt. Dabei erstrecken sich die Durchkontakte 425 durch das Detektorsubstrat 124 hindurch zu Kontaktstellen an der sensorchipseitigen Hauptoberfläche der Auswerteeinrichtung 130. Die Anschlusskontakte 150 sind an einer von dem Sensorchip 120 abgewandten Hauptoberfläche der Auswerteeinrichtung 130 angeordnet. Dabei sind die Anschlusskontakte 150 elektrisch leitfähig mit der Auswerteeinrichtung 130 verbunden. Der Dichtring 660 ist zwischen dem Sensorchip 120 und der Auswerteeinrichtung 130 angeordnet. Die Durchkontakte 425 sind innerhalb des Dichtrings 660 angeordnet.

Anders ausgedrückt sind das optische Detektorelement 122 und die Auswerteeinrichtung 130 mittels der durch das Detektorsubstrat 124 hindurch gebildeten Durchkontakte 425 sowie des zwischen dem Detektorsubstrat 124 und der Auswerteeinrichtung 130 angeordneten, umlaufenden Dichtrings 660 miteinander verbunden. Gemäß einem Ausführungsbeispiel sind die Durchkontakte 425 und der Dichtring 660 aus demselben Material ausgeformt. Unter Bezugnahme auf die Figuren 1 bis 6 wird im Folgenden eine optische Erfassungsvorrichtung gemäß einem weiteren Ausführungsbeispiel der vorliegenden Erfindung kurz beschrieben.

Die optische Erfassungsvorrichtung weist ein Sensorgehäuse für einen optischen Sensor/Sensorcluster bzw. für ein optisches Bauelement bestehend aus einem optischen Detektorelement 122, einer Auswerteschaltung 130 und einem optischen Element 110 auf. Dabei ist das optische Element 110 mit dem optischen Detektorelement 122 spaltfrei bzw. direkt, d. h. ohne Klebeschicht, verbunden. Das optische Element 110 ist von einer Linse oder einem komplanaren Fenster gebildet. Die Auswerteschaltung 130 und das Detektorelement 122 sind auf getrennten Halbleitersubstraten 124 und 140 realisiert. Die Auswerteschaltung 130 ist in das Auswertesubstrat 140 als ein Trägersubstrat, z. B. in Gestalt einer Leiterplatte, eingebettet. Das optische Element 110 weist mit mindestens einer Seitenfläche eine Verbindung nach außen auf. Das optische Detektorelement 122 bzw. der Sensorchip 120 ist in Vergussmasse 215 eingebettet, wobei das optische Element 110 diese Vergussmasse 215 überragt. Das Gehäuse der optischen Erfassungsvorrichtung weist entweder auf Seite des Auswertesubstrates 140 bzw. Trägersubstrates oder auf Seite des optischen Elements 110 Anschlusskontakte 150 bzw. Kontaktpads auf.

Die optische Erfassungsvorrichtung umfasst anders ausgedrückt ein Bauelement bestehend aus einem optischen Detektorelement 122, einem optischen Element 110 und einer Auswerteschaltung 130 bzw. einem Trägersubstrat 140 mit eingebetteter Auswerteschaltung 130, die alle drei dieselben Lateraldimensionen aufweisen und aufeinander gestapelt sind. Dabei sind das optische Detektorelement 122 und die Auswerteschaltung 130 über Silizium-Durchkontaktierungen 425 durch das Detektorsubstrat 124 und einen umlaufenden Dichtring 660 miteinander verbunden. Der Dichtring 660 und die Silizium-Durchkontaktierungen 425 sind beispielsweise aus demselben metallischen Material hergestellt. Die Anschlusskontakte 150 bzw. Kontaktpads sind insbesondere mittels Silizium-Durchkontaktierungen durch das Auswertesubstrat 140 nach außen geführt. Der Stapel kann zur Stressentkopplung gemäß einem Ausführungsbeispiel auf einem Trägersubstrat ebenfalls mit Substratdurchkontakten montiert sein.

Fig. 7 zeigt ein Ablaufdiagramm eines Verfahrens 700 zum Herstellen einer optischen Erfassungsvorrichtung gemäß einem Ausführungsbeispiel der vorliegenden Erfindung. Durch Ausführen des Verfahrens 700 ist eine optische Erfassungsvorrichtung wie die Erfassungsvorrichtung aus einer der Figuren 1 bis 6 vorteilhaft herstellbar.

Das Verfahren 700 weist einen Schritt 710 des Stapelns eines Detektorsubstrats, an dem ein optisches Detektorelement angeordnet ist, und eines Auswertesubstrats, an dem eine Auswerteeinrichtung angeordnet ist, aufeinander auf. Auch weist das Verfahren 700 einen Schritt 720 des Herstellens einer elektrisch leitfähigen Verbindung zwischen dem optischen Detektorelement und der Auswerteeinrichtung auf. Ferner weist das Verfahren 700 einen Schritt 730 des Anordnens eines optischen Elements angrenzend an das optische Detektorelement auf. Zudem weist das Verfahren 700 einen Schritt 740 des Verpackens zumindest des optischen Detektorelements und eines Teilabschnitts des optischen Elements mit einem Gehäusematerial auf.

Auch wenn es in Fig. 7 nicht gezeigt ist, so kann das Verfahren 700 auch einen Schritt des Erzeugens von Anschlusskontakten zum externen elektrischen Kontaktieren der optischen Erfassungsvorrichtung an einer detektorsubstratseitigen oder auswertesubstratseitigen Außenfläche der optischen Erfassungsvorrichtung aufweisen.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Optische Erfassungsvorrichtung (100), die ein optisches Detektorelement (122) und eine Auswerteeinrichtung (130) aufweist, **dadurch gekennzeichnet, dass** die optische Erfassungsvorrichtung (100) ein Detektorsubstrat (124) zum Tragen des optischen Detektorelements (122) aufweist, wobei das Detektorsubstrat (124) und die Auswerteeinrichtung (130) aufeinander gestapelt angeordnet sind.

2. Optische Erfassungsvorrichtung (100) gemäß Anspruch 1, mit einem Auswertesubstrat (140) zum Tragen der Auswerteeinrichtung (130).

3. Optische Erfassungsvorrichtung (100) gemäß Anspruch 2, bei der die Auswerteeinrichtung (130) in das Auswertesubstrat (140) eingebettet ist.

4. Optische Erfassungsvorrichtung (100) gemäß einem der vorangegangenen Ansprüche, bei der eine Grundfläche des Detektorelements (122) und eine Grundfläche der Auswerteeinrichtung (130) innerhalb eines Toleranzbereichs gleich groß sind.

5. Optische Erfassungsvorrichtung (100) gemäß einem der vorangegangenen Ansprüche, bei der Anschlusskontakte (150) zum externen elektrischen Kontaktieren der optischen Erfassungsvorrichtung (100) an einer detektorseitigen oder einer auswerteseitigen Außenfläche der optischen Erfassungsvorrichtung (100) angeordnet sind.

6. Optische Erfassungsvorrichtung (100) gemäß einem der vorangegangenen Ansprüche, mit einem optischen Element (110), das direkt, spaltfrei und/oder ohne Klebeschicht an das optische Detektorelement (122) angrenzend angeordnet ist.

7. Optische Erfassungsvorrichtung (100) gemäß Anspruch 6, bei der mindestens eine Außenoberfläche des optischen Elements (110) von einer Gehäuseaußenseite der optischen Erfassungsvorrichtung (100) her optisch zugänglich angeordnet ist.

8. Optische Erfassungsvorrichtung (100) gemäß einem der vorangegangenen Ansprüche, bei der zumindest das optische Detektorelement (122) in einer Vergussmasse (215) eingebettet ist.

9. Optische Erfassungsvorrichtung (100) gemäß einem der vorangegangenen Ansprüche, bei der das optische Detektorelement (122) und die Auswerteeinrichtung (130) mittels durch das Detektorsubstrat (124) hindurch gebildeter Durchkontakte (425) sowie eines zwischen dem Detektorsubstrat (124) und der Auswerteeinrichtung (130) angeordneten, umlaufenden Dichtrings (660) miteinander verbunden sind.

10. Optische Erfassungsvorrichtung (100) gemäß Anspruch 9, bei der die Durchkontakte (425) und der Dichtring (660) aus demselben Material ausgeformt sind.

11. Verfahren (700) zum Herstellen einer optischen Erfassungsvorrichtung (100), wobei das Verfahren (700) folgende Schritte aufweist:
Stapeln (710) eines Detektorsubstrats (124), an dem ein optisches Detektorelement (122) angeordnet ist, und einer Auswerteeinrichtung (130) aufeinander;
Herstellen (720) einer elektrisch leitfähigen Verbindung zwischen dem optischen Detektorelement (122) und der Auswerteeinrichtung (130);
Anordnen (730) eines optischen Elements (110) angrenzend an das optische Detektorelement (122); und
Verpacken (740) zumindest des optischen Detektorelements (122) und eines Teilabschnitts des optischen Elements (110) mit einem Gehäusematerial (215).
